(19) Europäisches Patentamt
European Patent Office
Office européen des brevets

(11) **EP 3 598 153 B1**

(12) **EUROPEAN PATENT SPECIFICATION**

(45) Date of publication and mention
of the grant of the patent:
**07.06.2023 Bulletin 2023/23**

(51) International Patent Classification (IPC):
**G01R 31/50** (2020.01)   **H02H 7/26** (2006.01)
**G01R 31/52** (2020.01)

(21) Application number: **17901312.3**

(52) Cooperative Patent Classification (CPC):
**G01R 31/52; H02H 7/26**

(22) Date of filing: **16.03.2017**

(86) International application number:
**PCT/JP2017/010647**

(87) International publication number:
**WO 2018/167909 (20.09.2018 Gazette 2018/38)**

(54) **LEAKAGE CURRENT DETECTION DEVICE, METHOD, AND PROGRAM FOR DETECTING LEAKAGE CURRENT**

LECKSTROMDETEKTOR, VERFAHREN UND PROGRAMM ZUM DETEKTIEREN DES LECKSTROMS

DISPOSITIF DE DÉTECTION DE COURANT DE FUITE, MÉTHODE ET PROGRAMME DE DÉTECTION DE COURANT DE FUITE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.01.2020 Bulletin 2020/04**

(73) Proprietor: **Kashiramoto, Yorikazu**
**Tokyo 168-0062 (JP)**

(72) Inventor: **Kashiramoto, Yorikazu**
**Tokyo 168-0062 (JP)**

(74) Representative: **Fédit-Loriot**
**22, rue du Général Foy**
**75008 Paris (FR)**

(56) References cited:
**JP-A- 2008 309 681       JP-A- 2008 309 681**
**JP-A- 2009 058 234       JP-A- 2009 145 122**
**JP-A- 2009 229 211       JP-A- 2010 127 860**
**JP-A- 2011 153 913       JP-A- 2015 064 265**
**JP-A- 2015 064 265       JP-A- 2016 070 877**

**Description**

TECHNICAL FIELD

The present invention relates to a leakage current detection device which detects a leakage current, a method of detecting a leakage current, and a program for detecting a leakage current.

BACKGROUND ART

Whereas utilization of electricity brings about convenience, the electricity may also pose serious danger if the electricity is inappropriately managed or erroneously used, and the likelihood that serious accidents such as electric fire and electric shock accidents are caused is not low.

For example, as one of the causes of the serious accidents, deeply related to an insulation failure of an electric circuit or an electric device is a leakage current I. Here, the leakage current I includes a leakage current (hereinafter, referred to as "Igc") which is attributed to a ground capacitance and a leakage current (hereinafter, referred to as "Igr") which is attributed to a ground insulation resistance directly related to an insulation resistance. The above-mentioned electric fire or any other problem is caused by the insulation resistance. Therefore, if only Igr can be accurately detected, it is made possible to check an insulation state of a circuit, thereby reducing catastrophic accidents such as electrical leakage fire.

For example, a leakage current breaker disclosed in PATENT DOCUMENT 1 includes, for example: a CT sensor that clamps the whole of an electric line to be measured A to be measured to detect a leakage current I flowing through the electric line to be measured A; a voltage detector that detects a voltage of the electric line to be measured A; a phase pulse width measuring section that measures a phase pulse width based on the leakage current I and the voltage of the electric line to be measured A; a power supply frequency measuring section that measures a power supply frequency based on the voltage of the electric line to be measured A; a phase angle calculator that calculates a phase angle of the leakage current I flowing through the electric line to be measured A based on the phase pulse width measured by the phase pulse width measuring section and the power supply frequency measured by the power supply frequency measuring section; and a leakage current calculator that calculates Igr based on the phase angle of the leakage current I calculated by the phase angle calculator and the leakage current I. JP 2015 064265 discloses a leakage current detection device monitoring a leakage current flowing through an electric line to be measured in a three-phase four-wire system based on a resistive component leakage current which is attributed to a ground insulation resistance and contained in the leakage current flowing through the electric line to be measured.

PRIOR ART DOCUMENT LIST

PATENT DOCUMENTS

PATENT DOCUMENT 1: Japanese Patent No. 4159590

SUMMARY

TECHNICAL PROBLEM

However, the leakage current breaker disclosed in PATENT DOCUMENT 1 is based on a connection system (the so-called delta-connection system) in which three phases are delta-connected and a wire of one of the three phases is grounded, and thus, the disclosed leakage current breaker is not applicable to a three-phase four-wire connection system (the so-called star-connection system) in which three phases are star-connected, a neutral point is grounded and a grounding wire is lead out therefrom.

In the star-connection system, ground voltages are generated in the three phases. As to a leakage current caused by insulation deterioration of an electric line, it is required to consider these voltages in the three phases. In other words, since the grounding configuration of a distribution line and portions where the voltages are generated in the connection system disclosed in PATENT DOCUMENT 1 are different from those in the star-connection system, the technique described in PATENT DOCUMENT 1 is not applicable to the star-connection system as it is.

Objects of the present invention are to provide a leakage current detection device which accurately detects an Igr, a method of accurately detecting the same, and a program for accurately detecting the same in a star-connection system.

SOLUTION TO THE PROBLEM

In order to achieve the above-mentioned objects, a leakage current detection device , as defined in claim 1, in one aspect of the present invention includes:

a leakage current detector that detects a leakage current flowing through an electric line to be measured in a three-phase four-wire system in which three phases (phase R, phase S, and phase T) are star-connected, a neutral point is grounded, and a grounding wire is lead out; a voltage detector that detects a voltage applied between any two of the three phases in the electric line to be measured; a phase difference detector that detects a phase difference based on the leakage current detected by the leakage current detector and the voltage detected by the voltage detector; a resistive component leakage current calculator that calculates a resistive component leakage current which is attributed to a ground insulation resistance and contained in the leakage current flowing through the electric line to be measured based on the phase difference detected by the phase difference detector and the leakage current detected by the leakage current detector; and a determination processor that determines whether or not the phase difference detected by the phase difference detector is within a predetermined range and if the phase difference is determined not to be within the predetermined range, transmits the phase difference detected by the phase difference detector to the voltage detector, wherein the voltage detector is switched so as to detect a voltage applied between the other two phases in the electric line to be measured based on the phase difference transmitted from the determination processor.

A method of detecting a leakage current, as defined in claim 5, according to another aspect of the present invention includes: a leakage current detecting step of detecting a leakage current flowing through an electric line to be measured in a three-phase four-wire system in which three phases (phase R, phase S, and phase T) are star-connected, a neutral point is grounded, and a grounding wire is lead out; a voltage detecting step of detecting a voltage applied between any two of the three phases in the electric line to be measured; a phase difference detecting step of detecting a phase difference based on the leakage current detected in the leakage current detecting step and the voltage detected in the voltage detecting step; a resistive component leakage current calculating step of calculating a resistive component leakage current which is attributed to a ground insulation resistance and contained in the leakage current flowing through the electric line to be measured based on the phase difference detected in the phase difference detecting step and the leakage current detected in the leakage current detecting step; and a determination processing step of determining whether or not the phase difference detected by the detecting the phase difference is within a predetermined range and if the phase difference is determined not to be within the predetermined range, transmitting the phase difference detected by the detecting the phase difference to the detecting the voltage, wherein in the voltage detecting step, the phases between which the voltage of the electric line to be measured has been detected are switched to other two phases based on the phase difference transmitted from the determination processing step to detect a voltage applied between the other two phases switched to.

A program of detecting a leakage current, as defined in claim 6, according to still another aspect of the present invention, the program comprising instructions to cause the device of claims 1-4 to execute the steps of the method of claim 5.

ADVANTAGES OF THE INVENTION

According to the present invention, Igr can be accurately detected in a star-connection system.

BRIEF DESCRIPTION OF THE DRAWINGS

[FIG. 1] FIG. 1 is a diagram showing a configuration of a leakage current detection device.
[FIG. 2] FIG. 2 is a diagram for explaining Igc contained in Igc.
[FIG. 3] FIG. 3 is a diagram for explaining relationship of a phase difference and Igr based on a first reference voltage.
[FIG. 4] FIG. 4 is a diagram for explaining relationship of a phase difference and Igr based on a second reference voltage.
[FIG. 5] FIG. 5 is a diagram for explaining relationship of a phase difference and Igr based on a third reference voltage.
[FIG. 6] FIG. 6 is a diagram for explaining a procedure of calculating Igr of each phase by a phase-to-phase resistive component leakage current calculator.
[FIG. 7] FIG. 7 is a diagram for explaining operation of the phase-to-phase resistive component leakage current calculator.
[FIG. 8] FIG. 8 is a diagram for explaining a configuration of a clamp.
[FIG. 9] FIG. 9 is a flowchart for explaining a procedure of detecting Igr using the leakage current detection device.

DETAILED DESCRIPTION

Hereinafter, an embodiment will be described in detail. Note that the present embodiment described below does not unjustly limit the content of the present invention described in the appended claims. In addition, all of the components described in the present embodiment are not necessarily requisite components of the present invention.

A leakage current detection device 1 detects a leakage current flowing through an electric line to be measured in a three-phase four-wire system in which three phases (phase R, phase S, and phase T) are star-connected, a neutral point is grounded, and a grounding wire G is lead out therefrom, and calculates a resistive component leakage current (hereinafter, referred to as "Igr") which is contained in the leakage current and attributed to a ground insulation resistance. Note that the leakage current I includes, in addition to Igr, a leakage current component (hereinafter, referred to as "Igc") which is attributed to a ground capacitance. A capacitance of Igc increases not only in accordance with a length of the electric line to be measured but also by a harmonic distortion current which is attributed to, for example, an inverter or a noise filter used in an electric device. An object of the leakage current detection device 1 is to extract Igr, which may cause electric fire or any other problem, from the leakage current.

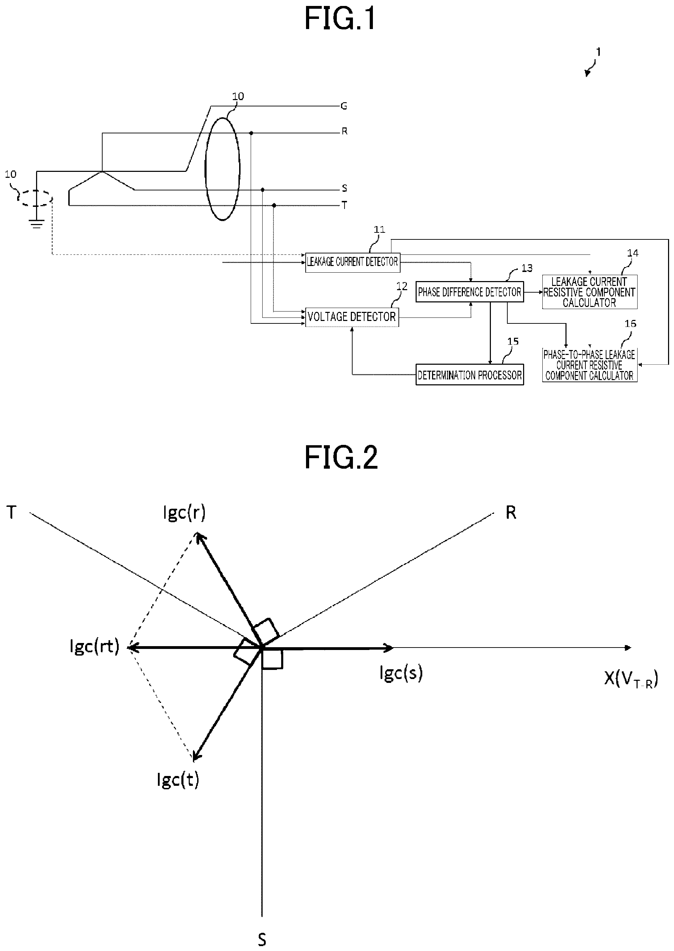

Hereinafter, a specific configuration of the leakage current detection device 1 will be described. As shown in FIG. 1, the leakage current detection device 1 includes: a leakage current detector 11; a voltage detector 12; a phase difference detector 13; a resistive component leakage current calculator 14; and a determination processor 15.

The leakage current detector 11 detects a leakage current I flowing through the electric line to be measured. Specifically, the leakage current detector 11 clamps the electric line to be measured by using a clamp 10 and detects the leakage current flowing through the electric line to be measured. Note that the clamp 10 may be configured to collectively clamp the three phases of the electric line to be measured as indicated by solid lines in FIG. 1 or may be configured to clamp only the grounding wire G as indicated by a dashed line in FIG. 1. In addition, the clamp 10 may be configured to selectively clamp one or more electric wires constituting the electric line to be measured or selectively clamp the electric lines constituting the electric line to be measured one by one.

Furthermore, the leakage current detector 11 calculates an effective value of the detected leakage current. The leakage current detector 11 outputs the calculated effective value of the leakage current to the phase difference detector 13 and the resistive component leakage current calculator 14.

The voltage detector 12 is formed by connecting all the three phases of the electric line to be measured, and detects a voltage applied between any two of the three phases. Hereinafter, a voltage detected between phase R and phase T is referred to as a first reference voltage VR-T, a voltage detected between phase T and phase S is referred to as a second reference voltage VT-S, and a voltage detected between phase S and phase R is referred to as a third reference voltage VS-R. To be precise, the voltage detector 12 outputs the effective values of the detected voltages to the phase difference detector 13.

The phase difference detector 13 detects a phase difference $\theta$ based on the effective value of the leakage current detected by the leakage current detector 11 and one of the effective values of the voltages (e.g., the first reference voltage VR-T) detected by the voltage detector 12. Specifically, the phase difference detector 13 detects the phase difference $\theta$ of the first reference voltage VR-T and the leakage current based on a zero-cross point of the first reference voltage VR-T and a zero-cross point of the leakage current.

The resistive component leakage current calculator 14 calculates the resistive component leakage current, which is contained in the leakage current flowing through the electric line to be measured and attributed to the ground insulation resistance, based on the phase difference $\theta$ detected by the phase difference detector 13 and the effective value of the leakage current detected by the leakage current detector 11.

Specifically, the resistive component leakage current calculator 14 calculates the resistive component leakage current Igr, which is contained in the leakage current flowing through the electric line to be measured and attributed to the ground insulation resistance, based on the phase difference $\theta$ detected by the phase difference detector 13 and the effective value I0 of the leakage current detected by the leakage current detector 11, using Equation (1). Note that a method of deriving Equation (1) will be described later.

$$\mathrm{Igr} = \mathrm{I0} \times \sin\theta/\cos(\pi/3) \qquad \dots (1)$$

<Discussion on Igc>

Here, Igc contained in the leakage current will be discussed with reference to FIG. 2. Note that Igc generated in phase R is referred to as Igc (r), Igc generated in phase T is referred to as Igc (t), and Igc generated in phase S is referred to as Igc (s). In addition, it is supposed that Igc (r), Igc (t), and Igc (s) are in equilibrium.

As shown in FIG. 2, Igc (r) is generated in a position to which a vector of phase R proceeds by $\pi/2$, and Igc (t) is generated in a position to which a vector of phase T proceeds by $\pi/2$. Therefore, Igc (rt) which is a composite vector of a vector of Igc (r) and a vector of Igc (t) can be indicated on the X-axis. In addition, Igc (s) is generated in a position (on the X-axis) to which a vector of phase S proceeds by $\pi/2$. Therefore, a vector Igc (rts) which is a composite component equivalent to capacitances of all of the three phases is canceled by the vector Igc (rt) and the vector Igc (s). In other words, when Igc (r), Igc (t), and Igc (s) which are equivalent to ground capacitances of the three phases are in equilibrium, it is unnecessary to consider the ground capacitances of the respective phases. Thus, the ground capacitances in the electric line to be measured can be canceled, and the resistive component leakage current Igr can be highly accurately detected without receiving any influence of higher harmonics and noise owing to filter effect.

<Operation of Determination Processor>

The determination processor 15 determines whether or not the phase difference detected by the phase difference detector 13 is within a predetermined range and if the phase difference is determined not to be within the predetermined range, transmits the phase difference detected by the phase difference detector 13 to the voltage detector 12. The voltage detector 12 is switched so as to detect a voltage applied between the other two phases in the electric line to be measured based on the phase difference transmitted from the determination processor 15.

Specifically, the determination processor 15 determines whether or not the phase difference $\theta$ detected by the phase difference detector 13 is included in the predetermined range of $\pi/6 \leq \theta \leq 5\pi/6$ and if the phase difference $\theta$ is not included in the predetermined range, transmits the phase difference $\theta$ to the voltage detector 12.

While the voltage (first reference voltage VR-T) applied between phase R and phase T of the electric line to be measured is being detected, if the phase difference $\theta$ is included within a range of $5\pi/6 \leq \theta \leq 3\pi/2$, the voltage detector 12 is switched so as to detect a voltage (second reference voltage VT-S) applied between phase T and phase S.

While the voltage, (first reference voltage VR-T) applied between phase R and phase T of the electric line to be measured is being detected, if the phase difference $\theta$ is included within a range of $3\pi/2 \leq \theta \leq 13\pi/6$, the voltage detector 12 is switched so as to detect a voltage (third reference voltage VS-R) applied between phase S and phase R.

In this way, employment of a moving origin method allows the leakage current detection device 1 to calculate Igr using Equation (1) even if the phase difference $\theta$ is within any range, and to accurately detect Igr in the star-connection system.

<Description on Moving Origin Method>

Here, the moving origin method will be described. Note that in the description below, supposing that the ground capacitances Igc (r), Igc (t), and Igc (s) of the three phases are in equilibrium, and the ground capacitance of each of the three phases is not considered.

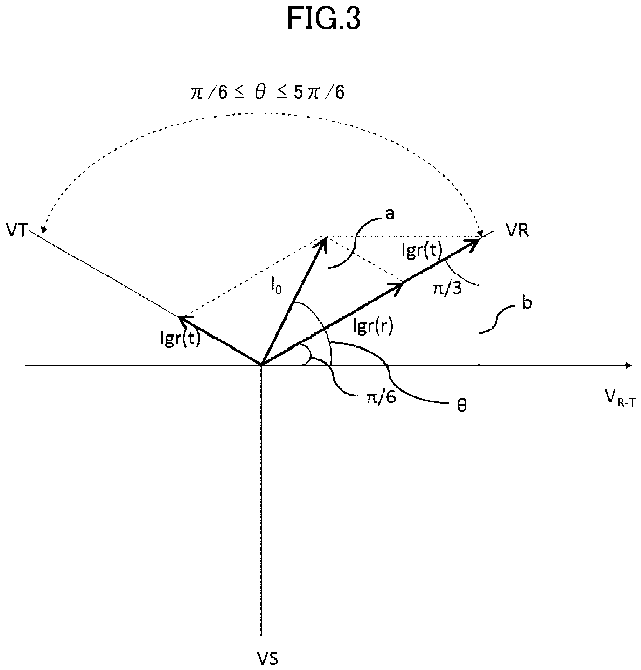

FIG. 3 is a diagram explaining Igr calculated by the resistive component leakage current calculator 14 based on the first reference voltage VR-T if the phase difference $\theta$ detected by the phase difference detector 13 is within the range of $\pi/6 \leq \theta \leq 5\pi/6$. Note that in FIG. 3, a case in which current leakage has occurred in both phase R and phase T is shown.

If the current leakage has occurred in both phase R and phase T, a resistive component leakage current Igr (r) and a resistive component leakage current Igr (t) are generated.

In addition, the ground capacitance of each of the three phases is not considered, and therefore, because a vector of the leakage current I0 is the sum of a vector of the resistive component leakage current Igr (r) in the same phase as a phase R voltage VR and a vector of the resistive component leakage current Igr (t) in the same phase as a phase T voltage VT, with the first reference voltage VR-T as reference ($\theta = 0$), the leakage current I0 is generated in the range of $\pi/6 \leq \theta \leq 5\pi/6$.

With the first reference voltage VR-T as reference ($\theta = 0$), if the leakage current 10 has been generated within the range of $\pi/6 \leq \theta \leq 5\pi/6$, it can be determined that Igr is generated only in the wire of phase R, only in the wire of phase T, or in both phase R and phase T. Note that if the current leakage has occurred only in the wire of phase R, $\theta$ is $\pi/6$ ($\theta = \pi/6$), and if the current leakage has occurred only in the wire of phase R, $\theta$ is $5\pi/6$ ($\theta = 5\pi/6$). If the current leakage has occurred in both phase R and phase T, the leakage current 10 is within a range of $\pi/6 < \theta < 5\pi/6$.

With reference to FIG. 3, Igr, where Igr = Igr (r) + Igr (t), generated between phases R and T can be derived as follows.

$$a = I0 \times \sin\theta \qquad \ldots (2)$$

$$b = Igr \times \cos(\pi/3) \qquad \ldots (3)$$

In addition, a is equal to b (a = b).

$$Igr = I0 \times \sin\theta/\cos(\pi 3) \quad \ldots (4)$$

Next, if the phase difference $\theta$ is included in the range of $5\pi/6 \leq \theta \leq 3\pi/2$, the voltage detector 12 is switched so as to detect a voltage (second reference voltage VT-S) applied between phase T and phase S.

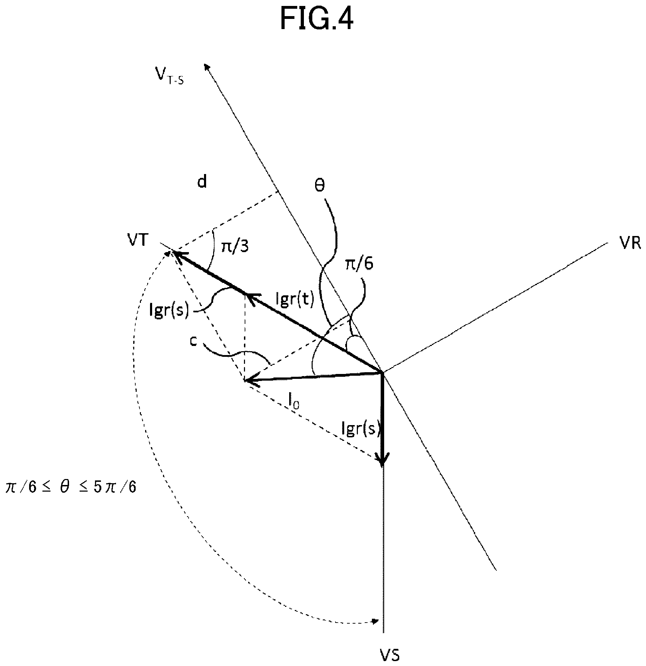

FIG. 4 is a diagram explaining Igr calculated by the resistive component leakage current calculator 14 based on the second reference voltage VT-S if the phase difference $\theta$ detected by the phase difference detector 13 is within the range of $\pi/6 \leq \theta \leq 5\pi/6$. Note that in FIG. 4, a case in which the current leakage has occurred in both phase R and phase T is shown.

If the current leakage has occurred in both phase T and phase S, a resistive component leakage current Igr (t) of phase T and a resistive component leakage current Igr (s) of phase S are generated.

In addition, the ground capacitance of each of the three phases is not considered, and therefore, because a vector of the leakage current I0 is the sum of a vector of the resistive component leakage current Igr (t) in the same phase as the phase T voltage VT and a vector of the resistive component leakage current Igr (s) in the same phase as a phase S voltage VS, with the second reference voltage VT-S as reference ($\theta$ = 0), the leakage current I0 is generated in the range of $\pi/6 \leq \theta \leq 5\pi/6$.

With the first reference voltage VR-T as reference ($\theta$ = 0), if the leakage current 10 has been generated within the range of $5\pi/6 \leq \theta \leq 3\pi/2$, it can be determined that Igr is generated only in the wire of phase T, only in the wire of phase S, or in both phase T and phase S. Note that if the current leakage has occurred only in the wire of phase T, $\theta$ is $5\pi/6$ ($\theta = 5\pi/6$), and if the current leakage has occurred only in the wire of phase S, $\theta$ is $3\pi/2$ ($\theta = 3\pi/2$). If the current leakage has occurred in both phase T and phase S, the leakage current I0 is within a range of $5\pi/6 < \theta < 3\pi/2$.

With reference to FIG. 4, Igr (Igr = Igr (t) + Igr (s)) generated between phase T and phase S can be derived as follows.

$$c = I0 \times \sin\theta \quad \ldots (5)$$

$$d = Igr \times \cos(\pi/3) \quad \ldots (6)$$

In addition, c is equal to d (c = d).

$$Igr = I0 \times \sin\theta/\cos(\pi/3) \quad \ldots (7)$$

In other words, since Equation (7) is identical to Equation (4), even if the phase difference $\theta$ is included in the range of $5\pi/6 \leq \theta \leq 3\pi/2$, it is not needed to modify the equation for calculating Igr.

Next, if the phase difference $\theta$ is included in the range of $3\pi/2 \leq \theta \leq 13\pi/6$, the voltage detector 12 is switched so as to detect a voltage (third reference voltage VS-R) applied between phase S and phase R.

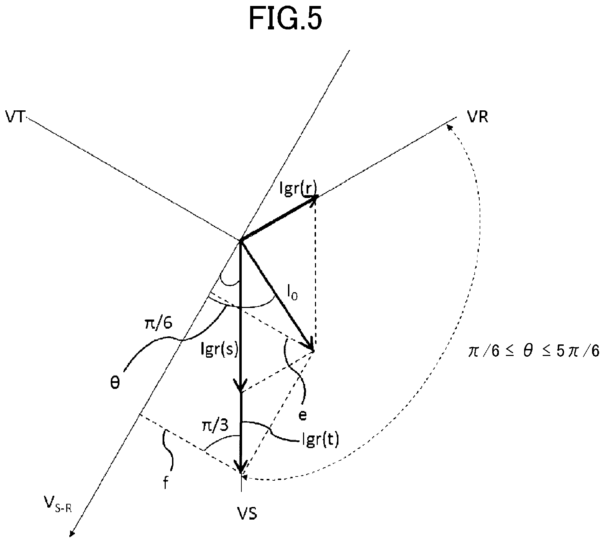

FIG. 5 is a diagram explaining Igr calculated by the resistive component leakage current calculator 14 based on the third reference voltage VS-R if the phase difference $\theta$ detected by the phase difference detector 13 is within the range of $\pi/6 \leq \theta \leq 5\pi/6$. Note that in FIG. 5, a case in which the current leakage has occurred in both phase S and phase R is shown.

If the current leakage has occurred in both phases S and phase R, a resistive component leakage current Igr (s) of phase S and a resistive component leakage current Igr (r) of phase R are generated.

In addition, the ground capacitance of each of the three phases is not considered, and therefore, because a vector of the leakage current I0 is the sum of a vector of the resistive component leakage current Igr (s) of phase S in the same phase as the phase S voltage VS and a vector of the resistive component leakage current Igr (r) in the same phase as the phase R voltage VR, with the third reference voltage VS-R as reference ($\theta$ = 0), the leakage current I0 is generated in the range of $\pi/6 \leq \theta \leq 5\pi/6$.

With the first reference voltage VR-T as reference ($\theta$ = 0), if the leakage current 10 has been generated within the range of $3\pi/2 \leq \theta \leq 13\pi/6$, it can be determined that Igr is generated only in the wire of phase S, only in the wire of phase R, or in both phase S and phase R. Note that if the current leakage has occurred only in the wire of phase S, $\theta$ is $3\pi/2$ ($\theta = 3\pi/2$), and if the current leakage has occurred only in the wire of phase R, $\theta$ is $13\pi/6$ ($\theta = \pi/6$). If the current leakage has occurred in both phase S and phase R, the leakage current I0 is within a range of $3\pi/2 < \theta < 13\pi/6$.

With reference to FIG. 5, Igr (Igr = Igr (s) + Igr (r)) generated between phase S and phase R can be derived

as follows.

$$e = I0 \times \sin\theta \qquad \ldots (8)$$

$$f = Igr \times \cos(\pi/3) \qquad \ldots (9)$$

In addition, e is equal to f (e = f).

$$Igr = I0 \times \sin\theta/\cos(\pi/3) \qquad \ldots (10)$$

In other words, since Equation (10) is identical to Equation (4) and Equation (7), even if the phase difference $\theta$ is included in the range of $5\pi/6 \le \theta \le 3\pi/2$, it is not needed to modify the equation for calculating Igr.

Thus, the employment of the moving origin method allows the leakage current detection device 1 to calculate Igr using Equation (1) even if the phase difference $\theta$ is in any range, thereby exhibiting an advantage that it is not needed to modify the equation for calculating Igr in accordance with the range of the phase difference $\theta$.

In addition, the reference voltage varies when a ground resistance varies with a change in the environment (e.g., a change from fine weather to rainy weather). In other words, errors occur when Igr generated between phase T and phase S or Igr generated between phase S and phase R is calculated based on the first reference voltage VR-T. Therefore, the leakage current detection device 1 takes the voltages in all of the three phases into the voltage detector 12, and employs the moving origin method changing the reference voltage based on the phase difference, thereby calculating accurate Igr even when a vector of the reference voltage is changed.

<Operation of Phase-to-Phase Resistive Component Leakage Current Calculator>

Furthermore, as shown in FIG. 1, the leakage current detection device 1 includes a phase-to-phase resistive component leakage current calculator 16 which calculates a resistive component leakage current of each of the three phases in which voltages are detected by the voltage detector 12 based on the leakage current detected by the leakage current detector 11, the resistive component leakage current calculated by the resistive component leakage current calculator 14, and the phase difference detected by the phase difference detector 13.

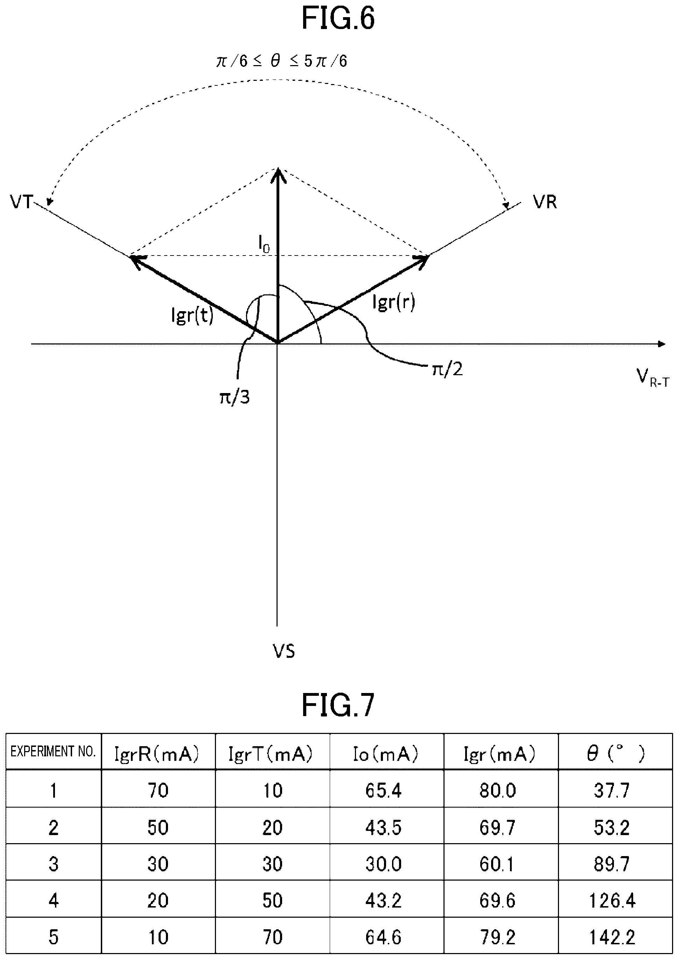

Here, as one example, a case in which a leakage current I0 is 10 mA and is generated in a position where a phase difference is 90 degrees will be described with reference to FIG. 6. Note that in the example shown in FIG. 6, it is supposed that a ground capacitance of each of the three phases is canceled, and the leakage current I0 is Igr.

The phase-to-phase resistive component leakage current calculator 16 calculates a resistive component leakage current Igr (r) in phase R as 10 mA and a resistive component leakage current Igr (t) in phase T as 10 mA.

In FIG. 7, experimental data is shown. Conditions for each experiment are as follows.

Test Date and Time: 13:00, February 24, 2017
Temperature/Humidity: 23°C/39%
Test Location: Experimental Laboratory in Shiba Annex 4F, SATORI ELECTRIC CO., LTD.
Serial Number of Apparatus: STRI1FZ0007
Program Ver. of Apparatus: 1.10.00
Power Source: MDAC-5A Manufactured by DENKEN Co., Ltd (Calibrated on September 21, 2016; Deadline: September 20, 2017)
Used Transformer: MCW-6-2040 (Y200V to Y400V) Manufactured by UNION ELECTRIC Co., Ltd.
Reference Voltage Frequency: 50 Hz
Phase Voltage: 200 V

In Experiment No. 1 shown in FIG. 7, a leakage current I0 and a phase difference $\theta$ were measured in a case in which a leakage current of 70 mA was generated in phase R and a leakage current of 10 mA was generated in phase T, and based on Equation (1), Igr was calculated. Experiment No. 2 and the subsequent experiments were conducted similarly appropriately changing a leakage current generated in the wire of phase R and a leakage current generated in the wire of phase T.

The experiment as described above was repeated at a plurality of times and a table in which combinations of leakage currents generated in phase R and leakage currents generated in phase T were listed was prepared.

Thus, the phase-to-phase resistive component leakage current calculator 16 can obtain Igr R generated in phase Rand Igr T generated in phase T based on Igr calculated by the resistive component leakage current calculator 14 and a phase difference $\theta$ detected by the phase difference detector 13 with reference to the table. Note that although in an example shown in FIG. 7, the case in which Igr was generated phase R and Igr was generated in phase T is shown, in actuality, experiments, in each of which a leakage current generated in phase T and a leakage current generated in phase S are appropriately changed, are conducted, thereby preparing a table, and experiments, in each of which a leakage current generated in phase S and a leakage current generated in phase R are appropriately changed, are conducted, thereby preparing a table.

The phase-to-phase resistive component leakage current calculator 16 refers to the table related to phase R and phase T at the first reference voltage VR-T, refers to the table related to phase T and phase S at the second reference voltage VT-S, and refers to the table related to phase S and phase R at the third reference voltage VS-R.

In addition, the phase-to-phase resistive component leakage current calculator 16 may configured to calculate Igr of each of the phases by substituting the leakage current I0, the phase difference $\theta$, and Igr into a predetermined function, instead of referring to the tables. Specifically, the phase-to-phase resistive component leakage current calculator 16 calculates Igr (r) by substituting the leakage current I0 detected by the leakage current detector 11 and the phase difference $\theta$ detected by the phase difference detector 13 into Equation (11). Next, the phase-to-phase resistive component leakage current calculator 16 calculates Igr (t) by substituting the calculated Igr (r) and Igr calculated by the resistive component leakage current calculator 14 into Equation (12).

$$\mathrm{Igr(r)} = \frac{2I_0 \sin\theta}{1 + \dfrac{\sqrt{3} - \tan(90 - \theta)}{\sqrt{3} + \tan(90 - \theta)}} \qquad \dots \quad (11)$$

$$\mathrm{Igr\,(t)} = \mathrm{Igr} - \mathrm{Igr\,(r)} \qquad \dots \quad (12)$$

Note that Equation (11) and Equation (12) are functions used for the first reference voltage VR-T. To be more precise, Equation (11) and Equation (12) are functions used if the phase difference $\theta$ is within a range of "$\pi/6 \le \theta \le \pi/2$." If the phase difference $\theta$ is in a range of "$\pi/2 \le \theta \le 5\pi/6$" at the first reference voltage VR-T, Equation (13) and Equation (14) are used.

$$\mathrm{Igr(t)} = \frac{2I_0 \sin\theta}{1 + \dfrac{\sqrt{3} - \tan(90 - \theta)}{\sqrt{3} + \tan(90 - \theta)}} \qquad \dots (13)$$

$$\mathrm{Igr\,(r)} = \mathrm{Igr} - \mathrm{Igr\,(t)} \qquad \dots (14)$$

Also, if the reference voltage is the second voltage VT-S and the reference voltage is the third reference voltage VS-R, functions which are suited for respective ranges of the phase differences $\theta$ are used.

In addition, the functions for calculating Igr of each of the phases are to obtain a rate of Igr generated in each of the phases from Igr calculated by the resistive component leakage current calculator 14 based on the phase difference $\theta$, are not limited to Equation (11) to Equation (14), and Igr of each of the phases may be calculated by other functions.

<Case of Current Leakage Simultaneously Occurring in Two Phases in Star Connection>

It is anticipated that likelihood that current leakage occurs simultaneously in two phases as mentioned above is low; however, when operation of a loading apparatus is examined, deterioration occurs in three phases while varying to some extend among the phases, and intermittent current leakage may occur.

In addition, as shown in FIG. 6, if grounding faults have occurred simultaneously in two phases of T and R, the leakage current I0 is 10 mA; however, Igr in which the resistive component leakage current Igr (r) in phase R and the resistive component leakage current Igr (t) in phase T are combined is 20 mA from Equation (1), resulting in Io < Igr.

In other words, if detection of the current leakage is made by relying on a value of the leakage current I0, it may occur that large Igr has been generated. In such a case, the leakage current detection device 1 can quickly and accurately detect Igr.

<Way of Clamping>

The clamp 10 may clamp only the electric line to be measured other than the grounding wire G as shown in FIG. 1 or may clamp all of the electric line to be measured and the grounding wire G. The former is a connection method mainly suited for a case in which the grounding wire G and any of t the phases of the electric line to be measured are connected to be used on a load side. The latter is a connection method mainly suited for a case in which a three-phase AC motor with all of the electric line to be measured connected is used on the load side.

<Measurement of Voltage>

If a high voltage (e.g., 6600 V) is applied to the electric line to be measured to be measured, the high voltage is stepped down to a predetermined voltage (for example, 200 V or 110 V) by using an earthing voltage transformer (EVT), and the stepped-down voltage is input to the voltage detector 12. Further, a phase shift may occur while stepping down the voltage. The phase difference detector 13 has a function to correct the phase shift caused by the earthing voltage transformer (EVT).

<Difference between Current Leakage Management by Insulation Resistance Test (Megger Testing) and Current Leakage Management by Igr Method>

In an insulation resistance test (megger testing), since a load is exerted on a measurement target by applying a high voltage thereto, an electric current is interrupted, a load is cut off from an electric line, and then, an insulation resistance is measured. That is to say, in the megger testing, the insulation resistance is measured while the electric current has been interrupted and the load has been cut off from the electric line.

On the other hand, in the Igr method according to the invention of the present application, an insulation resistance is measured while an electric current has been supplied and a load is connected to an electric line.

Therefore, the insulation resistance is measured by the megger testing in a peculiar state in which no electric current has been supplied. By contrast, the insulation resistance is measured by the Igr method while the electric current has been supplied. Although the same term is used, the insulation resistances measured by the methods are different from each other.

Further, in the megger testing, since it is required to interrupt the electric current, it is difficult to invariably measure (monitor) the insulation resistance. However, in the Igr method, the insulation resistance can be invariably measured (monitored).

As described above, as compared with the current leakage management by megger testing, the current leakage management by the Igr method allows a highly reliable insulation resistance to be invariably measured (monitored).

<Method>

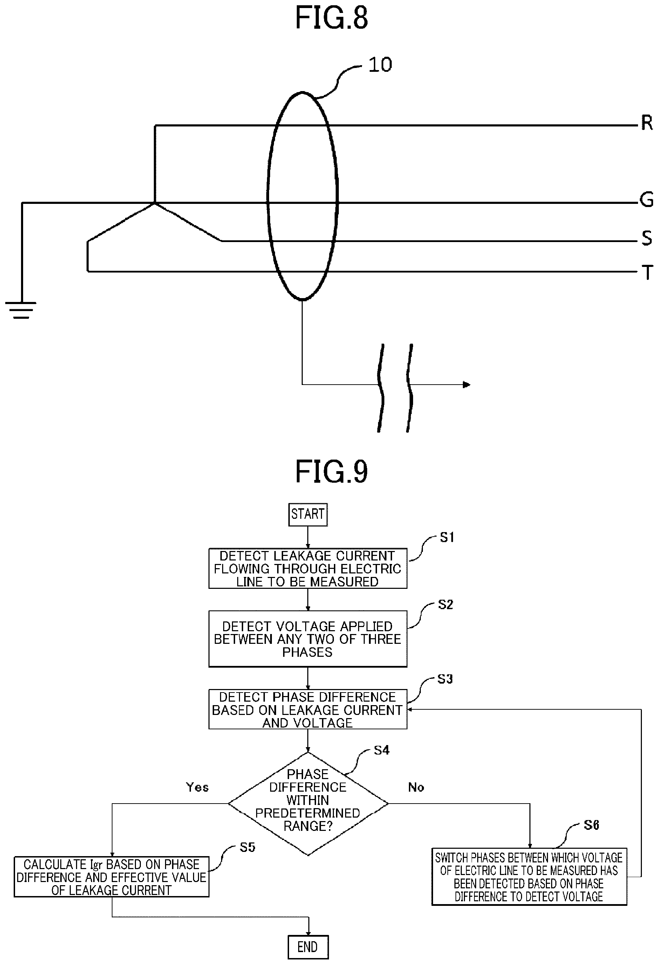

Next, a procedure of detecting Igr by the leakage current detection device 1 will be described with reference to a flowchart shown in FIG. 9.

In step S1, the leakage current detector 11 detects a leakage current flowing through an electric line to be measured in a three-phase four-wire system in which three phases (phase R, phase S, and phase T) are star-connected, a neutral point is grounded, and a grounding wire is lead out therefrom.

In step S2, the voltage detector 12 detects a voltage applied between any two of the three phases in the electric line to be measured.

In step S3, the phase difference detector 13 detects a phase difference based on the leakage current detected by step S1 and the voltage detected by step S2.

In step S4, the determination processor 15 determines whether or not the phase difference detected by step S3 is within a predetermined range. If the phase difference is determined to be within the predetermined range (Yes), the processing proceeds to step S5, whereas the phase difference is determined not to be within the predetermined range (No), the processing proceeds to step S6.

In step S5, the resistive component leakage current calculator 14 calculates a resistive component leakage current (Igr), which is contained in the leakage current flowing through the electric line to be measured and attributed to a ground insulation resistance, based on the phase difference detected by step S3 and an effective value of the leakage current detected by step S1.

In step S6, the voltage detector 12 is switched so as to detect a voltage applied between the other two phases in the electric line to be measured based on the phase difference. Thereafter, the processing returns to step S3, and in step S4, the processing is repeated until the phase difference is determined to be within the predetermined range.

Thus, the employment of the moving origin method allows the leakage current detection device 1 to calculate Igr using Equation (1), even if the phase difference θ is within any range, and to accurately detect Igr in the star-connection system.

<Program>

In the present embodiment, the configuration and the operation of the leakage current detection device 1 which accurately detects Igr in the star-connection system has been mainly described. However, the present invention is not limited thereto, and may be configured as a method and a program for accurately detecting Igr, using the respective components in the star-connection system.

Furthermore, the present invention may be achieved by recording, in a computer-readable recording medium, a program for realizing the respective functions which the leakage current detection device 1 has and by causing a computer system to read the program recorded in this recording medium and to execute the program.

Further, the "computer system" referred to herein includes hardware such as an OS and peripheral equipment. In addition, the "computer-readable recording medium" refers to a portable medium such as a flexible disk, a magneto-optical disk, a ROM, a CD-ROM and to a storage device such as a hard disk built in the computer system.

Further, the "computer-readable recording medium" may include a medium which dynamically holds a program for a short period of time, as with a communication line in a case in which a program is transmitted via a communication channel such as a phone line or a network such as the Internet, and a medium which holds a program for a fixed period of time, as with a volatile memory inside a computer system which serves as a server or a client in the above-mentioned case. In addition, the above-mentioned program may be to realize a part of the above-described functions, and further, the above-mentioned program and a program which has already been recorded in the computer system may be combined to realize the above-described functions.

DESCRIPTION OF REFERENCE CHARACTERS

1    Leakage Current Detection Device
10   Clamp
11   Leakage Current Detector
12   Voltage Detector
13   Phase Difference Detector
14   Resistive Component Leakage Current Calculator
15   Determination Processor
16   Phase-to-Phase Resistive Component Leakage Current Calculator

**Claims**

1.  A leakage current detection device comprising:

    a leakage current detector (11) that detects a leakage current flowing through an electric line to be measured in a three-phase four-wire system in which three phases (phase R, phase S, and phase T) are star-connected, a neutral point is grounded, and a grounding wire is lead out;
    a voltage detector (12) that detects a voltage applied between any two of the three phases in the electric line to be measured;
    a phase difference detector (13) that detects a phase difference based on the leakage current detected by the leakage current detector (11) and the voltage detected by the voltage detector (12); and
    a resistive component leakage current calculator (14) that calculates a resistive component leakage current which is attributed to a ground insulation resistance and contained in the leakage current flowing through the electric line to be measured based on the phase difference detected by the phase difference detector (13) and the leakage current detected by the leakage current detector (11); **characterized in that** the device further comprises:

        a determination processor (15) that determines whether or not the phase difference detected by the phase difference detector (13) is within a predetermined range and if the phase difference is determined not to be within the predetermined range, transmits the phase difference detected by the phase difference detector (13) to the voltage detector (12), wherein
the voltage detector (12) is switched so as to detect a voltage applied between the other two phases in the electric line to be measured based on the phase difference transmitted from the determination processor (15).

2. The leakage current detection device of claim 1, wherein

the determination processor (15) determines whether or not a phase difference $\theta$ detected by the phase difference detector (13) is included in a predetermined range of $\pi/6 \le \theta \le 5\pi/6$, and
while a voltage being applied between phase R and phase T of the electric line to be measured is being detected, if the phase difference $\theta$ is included in a range of $5\pi/6 \le \theta \le 3\pi/2$, the voltage detector (12) is switched so as to detect a voltage between phase T and phase S, and if the phase difference $\theta$ is included in a range of $3\pi/2 \le \theta \le 13\pi/6$, the voltage detector (12) is switched so as to detect a voltage between phase S and phase R.

3. The leakage current detection device of claim 1 or 2, wherein

the resistive component leakage current calculator (14) calculates a resistive component leakage current Igr contained in the leakage current flowing through the electric line to be measured based on the phase difference $\theta$ detected by the phase difference detector (13) and
an effective value I0 of the leakage current detected by the leakage current detector (11), the resistive component leakage current Igr being attributed to the ground insulation resistance by using Equation of Igr = I0 x $\sin\theta/\cos(\pi/3)$.

4. The leakage current detection device of any one of claims 1 to 3, further comprising:
a phase-to-phase resistive component leakage current calculator (16) that calculates a resistive component leakage current of each of the three phases whose voltages are detected by the voltage detector (12), based on the leakage current detected by the leakage current detector (11), the resistive component leakage current calculated by the resistive component leakage current calculator (14), and the phase difference detected by the phase difference detector (13).

5. A method of detecting a leakage current, the method comprising:

a leakage current detecting step of detecting a leakage current flowing through an electric line to be measured in a three-phase four-wire system in which three phases (phase R, phase S, and phase T) are star-connected, a neutral point is grounded, and a grounding wire is lead out;
a voltage detecting step of detecting a voltage applied between any two of the three phases in the electric line to be measured;
a phase difference detecting step of detecting a phase difference based on the leakage current detected in the leakage current detecting step and the voltage detected in the voltage detecting step; and
a resistive component leakage current calculating step of calculating a resistive component leakage current which is attributed to a ground insulation resistance and contained in the leakage current flowing through the electric line to be measured based on the phase difference detected in the phase difference detecting step and the leakage current detected in the leakage current detecting step; **characterized in that** the method further comprises:

a determination processing step of determining whether or not the phase difference detected by the detecting the phase difference is within a predetermined range and if the phase difference is determined not to be within the predetermined range, transmitting the phase difference detected by the detecting the phase difference to the detecting the voltage, wherein
in the voltage detecting step, the phases between which the voltage of the electric line to be measured has been detected are switched to other two phases based on the phase difference transmitted from the determination processing step to detect a voltage applied between the other two phases switched to.

6. A program for detecting a leakage current, the program comprising instructions to cause the device of any one of claims 1-4 to execute the steps of the method of claim 5.

**Patentansprüche**

1. Vorrichtung zur Erkennung von Leckstrom umfassend:

   einen Leckstromdetektor (11), der einen Leckstrom detektiert, der durch eine zu messende elektrische Leitung in einem dreiphasigen Vierleitersystem fließt, in dem drei Phasen (Phase R, Phase S und Phase T) sternförmig geschaltet sind, ein Nullpunkt geerdet ist und ein Erdungsdraht herausgeführt ist;
   einen Spannungsdetektor (12), der eine zwischen zwei beliebigen der drei Phasen der zu messenden elektrischen Leitung anliegende Spannung erfasst;
   einen Phasendifferenzdetektor (13), der eine Phasendifferenz basierend auf dem von dem Leckstromdetektor (11) erfassten Leckstrom und der von dem Spannungsdetektor (12) erfassten Spannung erfasst; und
   einen Widerstands-Komponenten-Leckstromrechner (14), der einen Widerstands-Komponenten-Leckstrom berechnet, der einem Erdungsisolationswiderstand zugeschrieben wird und in dem Leckstrom enthalten ist, der durch die zu messende elektrische Leitung fließt, basierend auf der Phasendifferenz, die von dem Phasendifferenzdetektor (13) erfasst wird, und dem Leckstrom, der von dem Leckstromdetektor (11) erfasst wird; **dadurch gekennzeichnet, dass** die Vorrichtung ferner umfasst:

   einem Bestimmungsprozessor (15), der bestimmt, ob die von dem Phasendifferenzdetektor (13) erfasste Phasendifferenz innerhalb eines vorbestimmten Bereichs liegt oder nicht, und falls bestimmt wird, dass die Phasendifferenz nicht innerhalb des vorbestimmten Bereichs liegt, die von dem Phasendifferenzdetektor (13) erfasste Phasendifferenz an den Spannungsdetektor (12) überträgt, wobei
   der Spannungsdetektor (12) so geschaltet wird, dass er eine zwischen den beiden anderen Phasen in der zu messenden elektrischen Leitung anliegende Spannung auf der Grundlage der vom Bestimmungsprozessor (15) übertragenen Phasendifferenz erfasst.

2. Die Leckstrom-Erfassungsvorrichtung nach Anspruch 1, wobei

   der Bestimmungsprozessor (15) bestimmt, ob eine von dem Phasendifferenzdetektor (13) erfasste Differenz 0 in einem vorbestimmten Bereich von $\pi/6 \leq 0 \leq 5\pi/6$ enthalten ist oder nicht, und
   während der Erfassung einer zwischen der Phase R und der Phase T der zu messenden elektrischen Leitung anliegenden Spannung, wenn die Phase 0 in einem Bereich von $5\pi/6 \leq 0 \leq 3\pi/2$ liegt, der Spannungsdetektor (12) so geschaltet wird, dass er eine Spannung zwischen der Phase T und der Phase S erfasst, und wenn die Phasendifferenz 0 in einem Bereich von $3\pi/2 \leq 0 \leq 13\pi/6$ liegt, der Spannungsdetektor (12) so geschaltet wird, dass er eine Spannung zwischen der Phase S und der Phase R erfasst.

3. Die Leckstrom-Erfassungsvorrichtung nach Anspruch 1 oder 2, wobei

   der Widerstands-Komponenten-Leckstromrechner (14) einen Widerstands-Komponenten-Leckstrom Igr berechnet, der in dem durch die zu messende elektrische Leitung fließenden Leckstrom enthalten ist, basierend auf der von dem Phasendifferenzdetektor (13) erfassten Phasendifferenz 0, und
   einen Effektivwert I0 des vom Leckstromdetektor (11) erfassten Leckstroms, wobei der Widerstandsanteil des Leckstroms Igr dem Erdungsisolationswiderstand unter Verwendung der Gleichung $Igr = I0 \times \sin 0/\cos(\pi/3)$ zugeschrieben wird.

4. Die Leckstrom-Erfassungsvorrichtung nach einem der Ansprüche 1 bis 3, ferner Folgendes umfasst:
   einen Phase-zu-Phase-Widerstandskomponenten-Leckstromrechner (16), der einen Widerstandskomponenten-Leckstrom jeder der drei Phasen, deren Spannungen von dem Spannungsdetektor (12) erfasst werden, auf der Grundlage des von dem Leckstromdetektor (11) erfassten Leckstroms, des von dem Widerstandskomponenten-Leckstromrechner (14) berechneten Widerstandskomponenten-Leckstroms und der von dem Phasendifferenzdetektor (13) erfassten Phasendifferenz berechnet.

5. Verfahren zur Erfassung eines Leckstroms, umfassend:

   einen Leckstromerfassungsschritt zum Erfassen eines Leckstroms, der durch eine zu messende elektrische Leitung in einem dreiphasigen Vierleitersystem fließt, in dem drei Phasen (Phase R, Phase S und Phase T) sternförmig verbunden sind, ein Neutralpunkt geerdet ist und ein Erdungsdraht herausgeführt ist;
   einen Spannungserfassungsschritt zum Erfassen einer Spannung, die zwischen zwei beliebigen der drei Phasen in der zu messenden elektrischen Leitung anliegt;

einen Phasendifferenz-Erfassungsschritt zum Erfassen einer Phasendifferenz auf der Grundlage des in dem Leckstrom-Erfassungsschritt erfassten Leckstroms und der in dem Spannungserfassungsschritt erfassten Spannung; und

einen Widerstands-Komponenten-Leckstrom-Berechnungsschritt zum Berechnen eines WiderstandsKomponenten-Leckstroms, der einem Erdungsisolationswiderstand zugeschrieben wird und in dem durch die zu messende elektrische Leitung fließenden Leckstrom enthalten ist, basierend auf der in dem Phasendifferenz-Erfassungsschritt erfassten Phasendifferenz und des in dem LeckstromErfassungsschritt erfassten Leckstroms; **dadurch gekennzeichnet, dass** das Verfahren ferner umfasst:

einen Bestimmungsverarbeitungsschritt des Bestimmens, ob die durch das Erfassen der Phasendifferenz erfasste Phasendifferenz innerhalb eines vorbestimmten Bereichs liegt oder nicht, und, falls bestimmt wird, dass die Phasendifferenz nicht innerhalb des vorbestimmten Bereichs liegt, des Übertragens der durch das Erfassen der Phasendifferenz erfassten Phasendifferenz an das Erfassen der Spannung, wobei

in dem Spannungserfassungsschritt die Phasen, zwischen denen die Spannung der zu messenden elektrischen Leitung erfasst worden ist, basierend auf der von dem Bestimmungsverarbeitungsschritt übertragenen Phasendifferenz, auf zwei andere Phasen umgeschaltet werden, um eine Spannung zu erfassen, die zwischen den beiden anderen Phasen anliegt, auf die umgeschaltet wird.

6. Programm zum Erfassen eines Leckstroms, das Anweisungen enthält, um die Vorrichtung nach einem der Ansprüche 1-4 zu veranlassen, die Schritte des Verfahrens nach Anspruch 5 auszuführen.

## Revendications

1. Dispositif de détection de courant de fuite comprenant :

un détecteur de courant de fuite (11) qui détecte un courant de fuite circulant à travers une ligne électrique devant être mesurée dans un système triphasé à quatre fils dans lequel trois phases (phase R, phase S, et phase T) sont connectées en étoile, un point neutre est mis à la masse, et un fil de mise à la masse est extrait ;

un détecteur de tension (12) qui détecte une tension appliquée entre deux phases quelconques parmi les trois phases dans la ligne électrique devant être mesurée ;

un détecteur de différence de phase (13) qui détecte une différence de phase sur la base du courant de fuite détecté par le détecteur de courant de fuite (11) et de la tension détectée par le détecteur de tension (12) ; et

un calculateur de courant de fuite de composante résistive (14) qui calcule un courant de fuite de composante résistive qui est attribué à une résistance d'isolation de masse et contenu dans le courant de fuite circulant à travers la ligne électrique devant être mesurée sur la base de la différence de phase détectée par le détecteur de différence de phase (13) et du courant de fuite détecté par le détecteur de courant de fuite (11) ; **caractérisé en ce que** le dispositif comprend en outre :

un processeur de détermination (15) qui détermine si la différence de phase détectée par le détecteur de différence de phase (13) est ou non au sein d'une plage prédéterminée et si la différence de phase est déterminée comme n'étant pas au sein de la plage prédéterminée, transmet la différence de phase détectée par le détecteur de différence de phase (13) au détecteur de tension (12), dans lequel

le détecteur de tension (12) est commuté de façon à détecter une tension appliquée entre les deux autres phases dans la ligne électrique devant être mesurée sur la base de la différence de phase transmise par le processeur de détermination (15).

2. Dispositif de détection de courant de fuite selon la revendication 1, dans lequel

le processeur de détermination (15) détermine si une différence de phase $\theta$ détectée par le détecteur de différence de phase (13) est comprise ou non dans une plage prédéterminée de $\pi/6 \leq \theta \leq 5\pi/6$, et tandis qu'une tension qui est appliquée entre la phase R et la phase T de la ligne électrique devant être mesurée est détectée, si la différence de phase $\theta$ est comprise dans une plage de $5\pi/6 \leq \theta \leq 3\pi/2$, le détecteur de tension (12) est commuté de façon à détecter une tension entre la phase T et la phase S, et si la différence de phase $\theta$ est comprise dans une plage de $3\pi/2 \leq \theta \leq 13\pi/6$, le détecteur de tension (12) est commuté de façon à détecter une tension entre la phase S et la phase R.

3. Dispositif de détection de courant de fuite selon la revendication 1 ou 2, dans lequel

le calculateur de courant de fuite de composante résistive (14) calcule un courant de fuite de composante résistive Igr contenu dans le courant de fuite circulant à travers la ligne électrique devant être mesurée sur la base de la différence de phase θ détectée par le détecteur de différence de phase (13) et une valeur efficace I0 du courant de fuite détecté par le détecteur de courant de fuite (11), le courant de fuite de composante résistive Igr étant attribué à la résistance d'isolation de masse en utilisant l'équation de Igr = I0 x sinθ/cos(π/3).

4. Dispositif de détection de courant de fuite selon l'une quelconque des revendications 1 à 3, comprenant en outre :
un calculateur de courant de fuite de composante résistive entre phases (16) qui calcule un courant de fuite de composante résistive de chacune des trois phases dont les tensions sont détectées par le détecteur de tension (12), sur la base du courant de fuite détecté par le détecteur de courant de fuite (11), du courant de fuite de composante résistive calculé par le calculateur de courant de fuite de composante résistive (14), et de la différence de phase détectée par le détecteur de différence de phase (13).

5. Procédé de détection d'un courant de fuite, le procédé comprenant :

une étape de détection de courant de fuite consistant à détecter un courant de fuite circulant à travers une ligne électrique devant être mesurée dans un système triphasé à quatre fils dans lequel trois phases (phase R, phase S, et phase T) sont connectées en étoile, un point neutre est mis à la masse, et un fil de mise à la masse est extrait ;
une étape de détection de tension consistant à détecter une tension appliquée entre deux phases quelconques parmi les trois phases dans la ligne électrique devant être mesurée ;
une étape de détection de différence de phase consistant à détecter une différence de phase sur la base du courant de fuite détecté à l'étape de détection de courant de fuite et de la tension détectée à l'étape de détection de tension ; et
une étape de calcul de courant de fuite de composante résistive consistant à calculer un courant de fuite de composante résistive qui est attribué à une résistance d'isolation de masse et contenu dans le courant de fuite circulant à travers la ligne électrique devant être mesurée sur la base de la différence de phase détectée à l'étape de détection de différence de phase et du courant de fuite détecté à l'étape de détection de courant de fuite ; **caractérisé en ce que** le procédé comprend en outre :

une étape de traitement de détermination consistant à déterminer si la différence de phase détectée par la détection de la différence de phase est ou non au sein d'une plage prédéterminée et si la différence de phase est déterminée comme n'étant pas au sein de la plage prédéterminée, transmettre la différence de phase détectée par la détection de la différence de phase à la détection de la tension, dans lequel
à l'étape de détection de tension, les phases entre lesquelles la tension de la ligne électrique devant être mesurée a été détectée sont commutées vers deux autres phases sur la base de la différence de phase transmise par l'étape de traitement de détermination pour détecter une tension appliquée entre les deux autres phases vers lesquelles la commutation a eu lieu.

6. Programme pour la détection d'un courant de fuite, le programme comprenant des instructions pour amener le dispositif selon l'une quelconque des revendications 1 à 4 à exécuter les étapes du procédé selon la revendication 5.

# FIG.1

# FIG.2

# FIG.3

# FIG.4

$\pi/6 \leq \theta \leq 5\pi/6$

# FIG.5

$$\pi/6 \leq \theta \leq 5\pi/6$$

# FIG.6

$$\pi/6 \leq \theta \leq 5\pi/6$$

# FIG.7

| EXPERIMENT NO. | IgrR(mA) | IgrT(mA) | Io(mA) | Igr(mA) | $\theta$ (°) |
|---|---|---|---|---|---|
| 1 | 70 | 10 | 65.4 | 80.0 | 37.7 |
| 2 | 50 | 20 | 43.5 | 69.7 | 53.2 |
| 3 | 30 | 30 | 30.0 | 60.1 | 89.7 |
| 4 | 20 | 50 | 43.2 | 69.6 | 126.4 |
| 5 | 10 | 70 | 64.6 | 79.2 | 142.2 |

...

# FIG.8

# FIG.9

START

DETECT LEAKAGE CURRENT FLOWING THROUGH ELECTRIC LINE TO BE MEASURED — S1

DETECT VOLTAGE APPLIED BETWEEN ANY TWO OF THREE PHASES — S2

DETECT PHASE DIFFERENCE BASED ON LEAKAGE CURRENT AND VOLTAGE — S3

PHASE DIFFERENCE WITHIN PREDETERMINED RANGE? — S4

Yes

No

CALCULATE Igr BASED ON PHASE DIFFERENCE AND EFFECTIVE VALUE OF LEAKAGE CURRENT — S5

SWITCH PHASES BETWEEN WHICH VOLTAGE OF ELECTRIC LINE TO BE MEASURED HAS BEEN DETECTED BASED ON PHASE DIFFERENCE TO DETECT VOLTAGE — S6

END

**EP 3 598 153 B1**

**REFERENCES CITED IN THE DESCRIPTION**

**Patent documents cited in the description**

- JP 2015064265 A
- JP 4159590 B